Europäisches Patentamt

European Patent Office

Office européen des brevets

(19)

(11) **EP 1 454 413 B1**

(12) **EUROPÄISCHE PATENTSCHRIFT**

(45) Veröffentlichungstag und Bekanntmachung des Hinweises auf die Patenterteilung:
**13.04.2005 Patentblatt 2005/15**

(51) Int Cl.[7]: **H03K 5/19**, G01R 29/02, F16H 61/02, F15B 19/00

(21) Anmeldenummer: **02804886.6**

(22) Anmeldetag: **10.12.2002**

(86) Internationale Anmeldenummer:
**PCT/EP2002/013978**

(87) Internationale Veröffentlichungsnummer:
**WO 2003/052931 (26.06.2003 Gazette 2003/26)**

(54) **VERFAHREN ZUR BERECHNUNG DER EINSCHALTDAUER VON HYDRAULISCHEN KOMPONENTEN**

METHOD FOR CALCULATING THE OPERATING TIME OF HYDRAULIC COMPONENTS

PROCEDE POUR CALCULER LE TEMPS DE FONCTIONNEMENT DE COMPOSANTS HYDRAULIQUES

(84) Benannte Vertragsstaaten:
**DE SE**

(30) Priorität: **15.12.2001 DE 10161742**

(43) Veröffentlichungstag der Anmeldung:
**08.09.2004 Patentblatt 2004/37**

(73) Patentinhaber: **ZF FRIEDRICHSHAFEN Aktiengesellschaft 88038 Friedrichshafen (DE)**

(72) Erfinder:
- **GANSOHR, Marcus 88682 Neufrach (DE)**
- **EBNER, Otto 88048 Friedrichshafen (DE)**
- **SCHWEIGER, Klaus 88046 Friedrichshafen (DE)**
- **WINKEL, Matthias 88250 Weingarten (DE)**
- **RÜCHARDT, Christoph 88131 Bodolz (DE)**
- **SCHWENGER, Andreas 38446 Wofsburg/Reislingen (DE)**
- **KNOBLAUCH, Thomas 66123 Saarbrücken (DE)**

(56) Entgegenhaltungen:
**US-A- 4 476 532 US-A- 6 157 671**

**Beschreibung**

Die vorliegende Erfindung betrifft ein Verfahren zur Berechnung der Einschaltdauer von hydraulischen, elektrohydraulischen oder elektrischen Komponenten eines Kraftfahrzeugs oder einer Arbeitsmaschine gemäß dem Oberbegriff des Patentanspruchs 1.

Üblicherweise werden bestimmte hydraulische, elektrohydraulische oder elektrische Komponenten eines Kraftfahrzeugs oder einer Arbeitsmaschine, wie z.B. Ventile oder Pumpen, nicht dauerfest ausgelegt, so dass eine maximal zulässige Einschaltdauer (ED) innerhalb einer Bezugszeit angegeben wird. Um eine Schädigung dieser Komponenten durch eine permanente Ansteuerung ausschließen zu können, muss den jeweiligen Steuereinrichtungen bzw. der Steuerungssoftware zu dem Zeitpunkt, an dem ein Ansteuersignal generiert wird, die aktuelle Einschaltdauer (ED) bekannt sein.

Für die Bestimmung der aktuellen Einschaltdauer wird die Ansteuerung einer Komponente beginnend vom augenblicklichen Zeitpunkt bis hin zu dem um die Bezugszeit zurückliegenden Zeitpunkt benötigt. Wird vom Steuergerät beispielsweise alle 5 ms ein Ansteuersignal generiert, so müssen bei einer Bezugszeit von beispielsweise 60 Sekunden 12 000 Einzelwerte für die Einschaltdauerberechnung betrachtet werden. Für eine exakte Bestimmung der Einschaltdauer müssten daher für jede Komponente diese Werte einzeln abgespeichert werden. Dieser Speicherplatz steht jedoch in der Regel aus Kostengründen auf einem Steuergerät nicht zur Verfügung.

Aus der US-A-4 476 532 ist ein Verfahren zur Bestimmung der aktuellen Einschaltdauer eines Ventils bekannt.

Der vorliegenden Erfindung liegt die Aufgabe zugrunde, ein Verfahren zur Bestimmung der aktuellen Einschaltdauer einer hydraulischen, elektrohydraulischen oder elektrischen Komponente eines Kraftfahrzeugs oder einer Arbeitsmaschine anzugeben, welches bei deutlich geringerem Speicherplatzbedarf als die nach dem Stand der Technik bekannten Verfahren eine möglichst genaue Bestimmung der aktuellen Einschaltdauer ermöglicht.

Diese Aufgabe wird durch die Merkmale des Patentanspruchs 1 gelöst. Weitere Varianten gehen aus den Unteransprüchen hervor.

Demnach wird vorgeschlagen, zur Berechnung der aktuellen Einschaltdauer ein Näherungsverfahren anzuwenden, wobei der Überwachungszeitraum bzw. die Bezugszeit in einzelnen Intervallen bzw. Zeitfenstern, die einer bestimmten Anzahl von Programm- bzw. Ansteuerdurchläufen entsprechen, unterteilt wird, wobei jedem Zeitfenster ein Wert zugeordnet wird, der durch die augenblickliche Ansteuerzeit erhöht wird. Die Einschaltdauer ergibt sich dann als Summe der Werte der einzelnen Zeitfenster, wobei ein oder mehrere Zeitfenster mit Gewichtungsfaktoren versehen werden können.

Durch das erfindungsgemäße Verfahren wird die Anzahl der Werte, die gespeichert werden müssen, erheblich reduziert; sie entspricht der Anzahl der Zeitfenster und dem gespeicherten Zähler.

Das Verfahren wird im folgenden anhand der beigefügten Figuren näher erläutert.

Fig. 1     stellt ein Zeit/Signal-Diagramm mit den entsprechenden Zeitfenstern für einen allgemeinen Fall dar und

Fig. 2     ist ein Zeit/Signal-Diagramm mit den erfindungsgemäßen Zeitfenstern für ein konkretes, im folgenden erläutertes Beispiel.

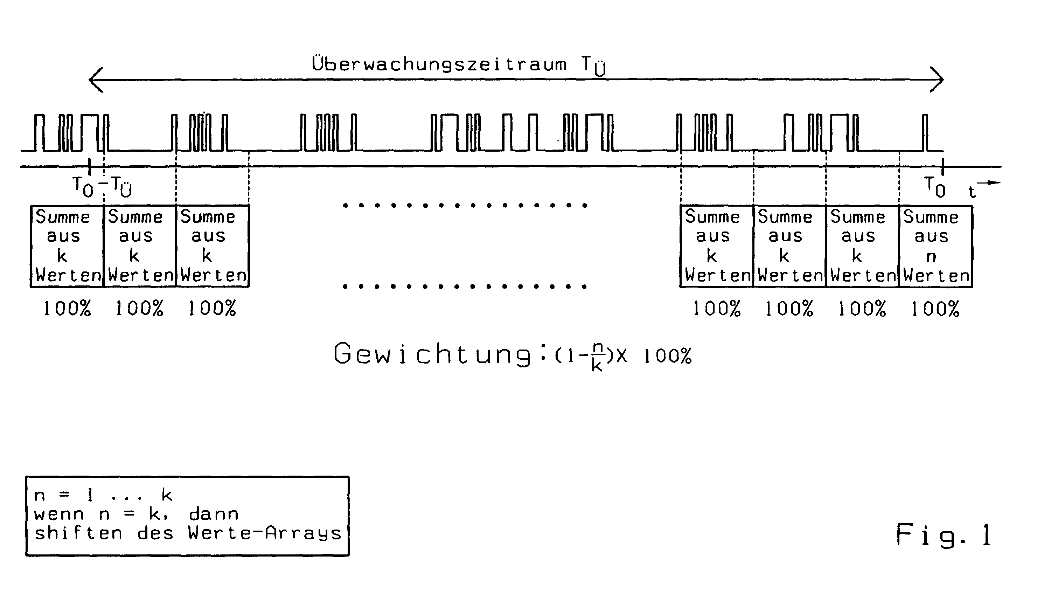

Wie in Fig. 1 gezeigt, wird gemäß der Erfindung der Überwachungs- bzw. Bezugszeitraum in einzelne Zeitfenster unterteilt, wobei jedes Zeitfenster die Länge von k Ansteuer- bzw. Programmdurchläufen aufweist. Hierbei kann die Zahl k anhand der gewünschten zu erreichenden Genauigkeit der Berechnung definiert werden. Je größer k ist, desto geringer ist die erzielbare Genauigkeit, da mehrere Werte zusammengefasst werden.

Die Einschaltzeit der jeweiligen Komponente während eines dieser Zeitfenster wird als ein Wert abgespeichert, wobei der Wert des aktuellen Zeitfensters mit jedem Programmdurchlauf durch die augenblickliche Ansteuerzeit der Komponente erhöht wird. Nach k Programmdurchläufen, die von einem Zähler n erfasst werden, rückt das gerade abgelaufene Zeitfenster an die zweite Stelle, der Zähler n wird zurückgesetzt und der Wert des am weitesten zurückliegenden Zeitfensters wird gelöscht, wodurch der freigewordene Speicherplatz zur Aufzeichnung der Einschaltdauer im neuen, aktuellen Zeitfenster zur Verfügung steht. Insgesamt verändert sich die Anzahl der Zeitfenster nicht.

Die Berechnung der Einschaltdauer innerhalb des überwachungszeitraums erfolgt gemäß der Erfindung durch Bildung der Summe aus allen Werten der einzelnen Zeitfenster. Eine Variante der Erfindung sieht eine Gewichtung der einzelnen Fenster mittels eines zugehörigen Gewichtungsfaktors vor.

Gemäß einer besonders vorteilhaften Variante der Erfindung verliert das am weitesten zurückliegende Zeitfenster mit zunehmendem Füllstand (Zähler n) des aktuellen Zeitfensters an Einfluß. Hierbei wird das am weitesten zurückliegende Zeitfenster mit dem Faktor (1-n/k) gewichtet, wobei n den Zähler des aktuellen Zeitfensters darstellt.

Die Bestimmung der Anzahl der für die Speicherung der gesamten Einschaltdauer im Überwachungszeitraum notwendigen Zeitfenster ergibt sich aus folgender Formel:

$$\text{Anzahl Zeitfenster} = \left( \frac{T_{\ddot{U}}/T_p}{k} \right) + 1,$$

mit

$T_{\ddot{U}}$ = Überwachungszeitraum
$T_p$ = Programmdurchlaufzeit
k = Anzahl der Werte pro Zeitfenster

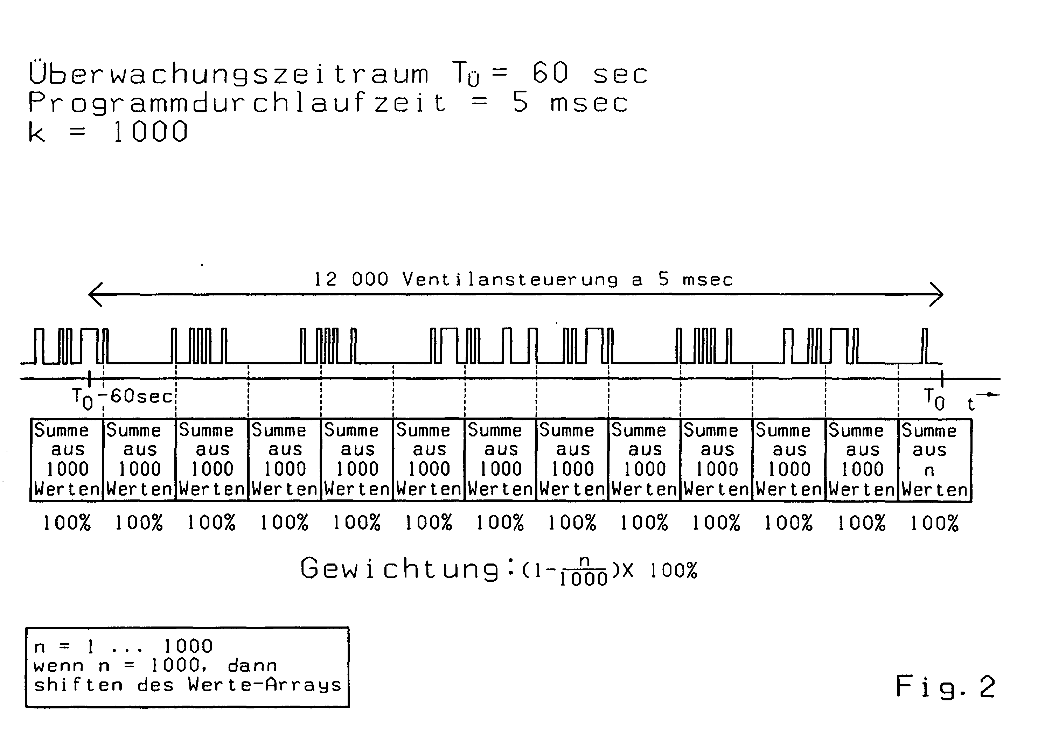

Beispielsweise ergeben sich für eine Programmdurchlaufzeit von 5 Millisekunden, einen Überwachungszeitraum von 60 Sekunden und den Wert 1 000 für den Faktor k 13 Zeitfenster mit einer Länge von jeweils 5 Sekunden. Das zu diesen Werten korrespondierende Diagramm ist Gegenstand der Fig. 2.

Die Genauigkeit der Einschaltdauerberechnung wird, wie bereits erläutert, hauptsächlich durch den Faktor k bestimmt. Des weiteren tritt die maximal mögliche Abweichung des berechneten Wertes vom tatsächlichen Wert genau zum Zeitpunkt des Programmdurchlaufs auf, an dem die Bedingung n = k/2 erfüllt ist. Der typische Maximalwerte für den auftretenden Fehler in einer derartigen Situation liegt in der Größenordnung von ±2.0 % und kann nur durch ein ganz bestimmtes Ansteuersignal erreicht werden für k = 1 000 und 13 Zeitfenster; für den Normalfall ist hingegen ein Fehler von ca. ±1.0 % zu erwarten, wobei für den jeweiligen Anwendungsfall ein Kompromiss zwischen Genauigkeit und Speicherbedarf zu finden ist.

Bezugszeichen

$T_{\ddot{U}}$ Überwachungszeitraum
$T_p$ Programmdurchlaufzeit
k Anzahl der Werte pro Zeitfenster
n Zähler

**Patentansprüche**

1. Verfahren zur Bestimmung der aktuellen Einschaltdauer einer hydraulischen, elektrohydraulischen oder elektrischen Komponente eines Kraftfahrzeugs oder einer Arbeitsmaschine innerhalb einer Bezugzeit bzw. eines Überwachungszeitraumes, bei dem die aktuelle Einschaltdauer mittels eines Näherungsverfahrens bestimmt wird, **dadurch gekennzeichnet, dass** der Überwachungszeitraum bzw. die Bezugzeit in einzelnen Intervallen bzw. Zeitfenstern, die einer bestimmten Anzahl k von Programm- bzw. Ansteuerdurchläufen entsprechen, unterteilt wird, wobei jedem Zeitfenster ein Wert zugeordnet wird, der durch die augenblickliche, aktuelle Ansteuerzeit erhont und anschließend gespeichert wird und dass nach k Programmdurchläufen, die von einem Zähler n erfasst werden, das gerade abgelaufene Zeitfenster an die zweite Stelle rückt, ein neues Fenster entsteht, der Zähler n zurückgesetzt wird und der Wert des am weitesten zurückliegenden Zeitfensters gelöscht wird, wobei die Berechnung der Einschaltdauer innerhalb des Überwachungszeitraums durch Bildung der Summe aus allen Werten der einzelnen Zeitfenster erfolgt.

2. Verfahren nach Anspruch 1, **dadurch gekennzeichnet, dass** die Werte eines oder mehrerer Zeitfenster mittels eines Gewichtungsfaktors gewichtet werden.

3. Verfahren nach Anspruch 2, **dadurch gekennzeichnet, dass** das am weitesten zurückliegende Zeitfenster mit dem Faktor (1-n/k) gewichtet wird.

**Claims**

1. Method for determining the on-time of a hydraulic, an electrohydraulic or electric component of a motor vehicle or of a work machine within a reference or monitoring period, with the on-time being determined through approximation, **characterized** **in that** the reference or monitoring period is split into intervals or time slots, which correspond to a certain number k of program or control processes, with each time slot being assigned a value, which is increased by the instantaneous, current control time and is subsequently saved, and **in that** after k program processes, which are recorded by a counter n, the time slot expiring takes second place, a new time slot is created, the counter n is reset, and the value of the time slot furthest in the past is deleted, with calculation of the on-time within the monitoring period being based on the sum of all values of the individual time slots.

2. Method according to claim 1, **characterized** **in that** the values of one or several time slots are weighted by means of a weighting factor.

3. Method according to claim 2, **characterized** **in that** the time slot furthest in the past is weighted with the factor (1-n/k).

**Revendications**

1. Méthode pour déterminer la durée de service courante d'une composante hydraulique, électrohydraulique ou électrique d'un véhicule automobile ou d'une machine de travail dans une période de référence et/ou dans une période de surveillance, sachant que la durée de service courante est déterminée au moyen d'un procédé d'approximation, **caractérisée en ce que** la période de surveillance et/ou la période de référence seront subdivisées en différents intervalles et/ou créneaux horaires qui correspondent à un nombre déterminé k de cycles de programme et/ou cycles de pilotage, sachant qu'à chaque créneau horaire est assignée une valeur qui est augmentée par le temps de pilotage momentané et courant et ensuite enregistrée, et **en ce qu'**à l'issue de k cycles de programme, qui seront enregistrés par un compteur n, le créneau horaire venant de s'écouler avance à la deuxième position, **en ce qu'**un nouvel créneau horaire sera créé, le compteur étant remis à zéro et la valeur du créneau horaire le moins récent étant effacée, sachant que le calcul de la durée de service à l'intérieur d'une période de surveillance s'effectue par la formation de la somme de toutes les valeurs des différents créneaux horaires.

2. Méthode selon la revendication 1, **caractérisée en ce que** les valeurs d'un ou de plusieurs créneaux horaires sont pondérées à l'aide d'un facteur de pondération.

3. Méthode selon la revendication 2, **caractérisée en ce que** le créneau horaire le moins récent est pondéré par le facteur (1-n/k).

Figur: Überwachungszeitraum $T_{Ü}$

$T_0 - T_{Ü}$

$T_0$  t

Summe aus k Werten | Summe aus k Werten | Summe aus k Werten ... Summe aus k Werten | Summe aus k Werten | Summe aus k Werten | Summe aus n Werten

100%  100%  100%  ...  100%  100%  100%  100%

Gewichtung: $(1 - \frac{n}{k}) \times 100\%$

n = 1 ... k
wenn n = k, dann
shiften des Werte-Arrays

Fig. 1

EP 1 454 413 B1

Überwachungszeitraum $T_{\ddot{u}} = 60$ sec
Programmdurchlaufzeit = 5 msec
k = 1000

12 000 Ventilansteuerung a 5 msec

EP 1 454 413 B1

$T_0$ -60sec

| Summe aus 1000 Werten | Summe aus 1000 Werten | Summe aus 1000 Werten | Summe aus 1000 Werten | Summe aus 1000 Werten | Summe aus 1000 Werten | Summe aus 1000 Werten | Summe aus 1000 Werten | Summe aus 1000 Werten | Summe aus 1000 Werten | Summe aus 1000 Werten | Summe aus 1000 Werten | Summe aus n Werten |
|---|---|---|---|---|---|---|---|---|---|---|---|---|
| 100% | 100% | 100% | 100% | 100% | 100% | 100% | 100% | 100% | 100% | 100% | 100% | 100% |

$T_0$ t

Gewichtung: $(1 - \frac{n}{1000}) \times 100\%$

n = 1 ... 1000
wenn n = 1000, dann
shiften des Werte-Arrays

Fig. 2